# FASCICULE DE BREVET EUROPEEN

(11) **EP 3 675 363 B1**
(45) Date de publication et mention de la délivrance du brevet: **08.10.2025**
(21) Numéro de dépôt: 19219572.5
(22) Date de dépôt: 23.12.2019
(51) Int. Cl.: H03L 7/22, H03L 1/02

(54) **PROCEDE DE CALIBRATION EN PHASE D'UN CIRCUIT ELECTRONIQUE REALISANT LA SOMMATION COHERENTE DE DEUX BOUCLES A VERROUILLAGE DE PHASE**
PHASEN-KALIBRIERVERFAHREN EINES ELEKTRONISCHEN SCHALTKREISES, DER DIE KOHÄRENTE SUMMIERUNG VON ZWEI PHASENREGELSCHLEIFEN AUSFÜHRT
METHOD FOR CALIBRATING THE PHASE OF AN ELECTRONIC CIRCUIT PERFORMING COHERENT SUMMATION OF TWO PHASE LOCKED LOOPS

(30) Priorité: 27.12.2018 FR 1874269
(43) Date de publication de la demande: 01.07.2020
(73) Titulaire: Avantix, 13100 Aix-en-Provence (FR)
(72) Inventeur: LEZAUD, Nicolas, 95870 BEZONS (FR)
(74) Mandataire: Plasseraud IP

(56) Documents cités:
- GB-A- 2 040 128
- US-A- 5 014 061
- US-A1- 2009 296 751
- US-B1- 6 960 943
- NARESH SATYAN ET AL: "Phase-Controlled Apertures Using Heterodyne Optical Phase-Locked Loops", IEEE PHOTONICS TECHNOLOGY LETTERS, IEEE SERVICE CENTER, PISCATAWAY, NJ, US, vol. 19, no. 11, 1 June 2008 (2008-06-01), pages 897 - 899, XP011214478, ISSN: 1041-1135
- CHENGCHENG TANG ET AL: "An Array of Coherent Sources Based on Novel Dual-Loop PLL Infrastructure", IEEE TRANSACTIONS ON INDUSTRIAL ELECTRONICS, IEEE SERVICE CENTER, PISCATAWAY, NJ, USA, vol. 60, no. 11, 1 November 2013 (2013-11-01), pages 5337 - 5347, XP011514282, ISSN: 0278-0046, DOI: 10.1109/TIE.2012.2227916

## Description

### DOMAINE DE L'INVENTION

L'invention concerne le domaine des procédés de calibration en phase d'un circuit électronique réalisant la sommation cohérente de deux boucles à verrouillage de phase, ainsi que le domaine des circuits électroniques réalisant la sommation cohérente de deux boucles à verrouillage de phase calibrés en phase.

### ARRIERE PLAN TECHNOLOGIQUE DE L'INVENTION

Pour améliorer le bruit de phase des boucles à verrouillage de phase (PLL pour « phase-locked loop » en langue anglaise), le circuit électronique réalise la sommation cohérente de deux boucles à verrouillage de phase. La sommation cohérente est la sommation de deux signaux identiques en phase. Le signal utile est augmenté de 6dB alors que le bruit blanc de seulement 3dB, permettant ainsi l'amélioration de 3dB du bruit de phase.

Le principal intérêt de réaliser la sommation cohérente de deux boucles à verrouillage de phase plutôt que de prendre directement le signal à la sortie d'une boucle à verrouillage de phase réside dans le fait que le rapport signal sur bruit est ainsi amélioré.

Cette amélioration n'est toutefois valable que si le déphasage entre les deux boucles à verrouillage de phase reste faible, c'est-à-dire en dessous d'un seuil donné.

Or, les deux boucles à verrouillage de phase peuvent voir leur déphasage dériver dans le temps, d'autant plus que la différence de température entre les boîtiers des deux boucles à verrouillage de phase dérive dans le temps et que la fréquence augmente.

C'est pourquoi, il est procédé à un calibrage ou à un recalibrage à certains moments.

Mais la mesure de ce déphasage entre les deux boucles à verrouillage de phase est réalisée à partir de la mesure de puissance en sortie de sommation cohérente des deux boucles à verrouillage de phase.

L'imprécision de mesure de cette puissance impacte directement l'imprécision de mesure de ce déphasage lequel doit rester le plus faible possible et en-dessous d'un certain seuil.

Une solution possible consisterait à essayer d'améliorer la précision intrinsèque de la détermination de la puissance de manière à améliorer mécaniquement et automatiquement la précision intrinsèque de la détermination du déphasage.

Des exemples et modes de réalisation de l'art antérieur peuvent être trouvés dans US 2009/296751 A1; Naresh Satyan et al: "Phase-Controlled Apertures Using Heterodyne Optical Phase-Locked Loops", IEEE PHOTONICS TECHNOLOGY LETTERS, IEEE SERVICE CENTER, PISCATAWAY, NJ, US, vol. 19, no. 11, 1 juin 2008 (2008-06-01), pages 897-899; GB 2 040 128 A; US 6 960 943 B1; US 5 014 061 A; Chengcheng Tang et al: "An array of Coherent Sources Based on Novel Dual-Loop PLL Infrastructure", IEEE TRANSACTIONS ON INDUSTRIAL ELECTRONICS, IEEE SERVICE CENTER, PISCATAWAY, NJ, USA, vol. 60, no. 11, 1 novembre 2013 (2013-11-01), pages 5337-5347.

### OBJETS DE L'INVENTION

Le but de la présente invention est de fournir un procédé de calibration en phase palliant au moins partiellement les inconvénients précités.

Plus particulièrement, l'invention vise à fournir une autre solution qui choisit la zone de calibration de sorte qu'une imprécision donnée dans la mesure de la puissance en sortie de sommation cohérente des deux boucles à verrouillage de phase ait la plus faible répercussion possible sur l'imprécision résultante du déphasage entre les deux boucles à verrouillage de phase.

Pour cela, l'invention propose de choisir, comme zone de calibration, une zone où une variation importante de la puissance n'entraîne qu'une variation modérée du déphasage, et même une zone où la variation est la plus rapide de la courbe du gain en puissance en fonction du déphasage entre les deux boucles à verrouillage de phase.

Ainsi, l'effet d'une imprécision donnée dans la mesure de la puissance aura un impact minimal et même minimisé sur l'imprécision résultante dans la mesure du déphasage.

A cette fin, la présente invention propose un procédé de calibration tel que définit dans la revendication 1.

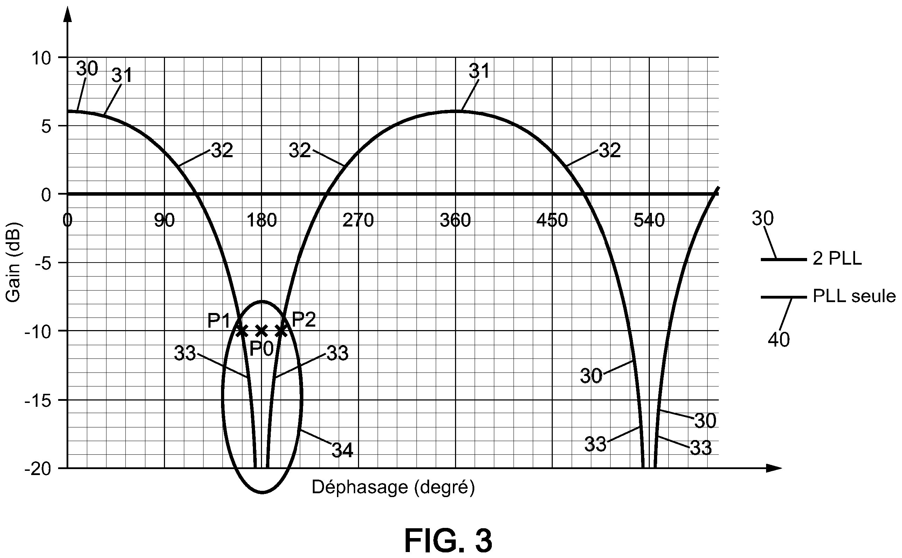

C'est la zone de variation la plus rapide de la courbe du gain en puissance en fonction du déphasage entre les deux boucles à verrouillage de phase, pour un gain préférentiellement de niveau suffisant, par exemple au-dessus de -30dB, ou au-dessus de -20dB, de préférence entre -20dB et -10dB comme sur la figure 3 présentée ultérieurement. Cette zone de variation va se trouve préférentiellement autour de l'opposition de phase à 180 degrés, à plus ou moins 10, 20 ou 30 degrés autour de l'opposition de phase à 180 degrés.

De préférence, la courbe, du gain en puissance en fonction du déphasage entre les deux boucles à verrouillage de phase en sortie de la sommation cohérente des deux boucles à verrouillage de phase, présente une forme de parabole inversée, la zone de calibration étant choisie au niveau d'une branche ou des branches de cette parabole inversée, mais ni au niveau du dôme de cette parabole inversée ni au niveau de la zone intermédiaire entre ce dôme et ces branches.

A cette fin, la présente invention propose aussi un procédé de fonctionnement dudit circuit électronique tel que défini dans la revendication 7.

Ainsi, lorsque le déphasage dérive un peu, une calibration est relancée pour conserver l'amélioration de précision due à la sommation cohérente des deux boucles à verrouillage de phase, tandis que lorsque le déphasage dérive beaucoup, la deuxième boucle à verrouillage de phase est alors supprimée puisque non seulement la sommation cohérente des deux boucles à verrouillage de phase n'améliore plus vraiment la situation par rapport à l'utilisation d'une seule boucle à verrouillage de phase, mais elle pourrait même dégrader cette situation, en plus de consommer notablement plus d'énergie.

A cette fin, la présente invention propose également un circuit électronique réalisant la sommation cohérente de deux boucles à verrouillage de phase tel que défini dans la revendication 9.

Ainsi, non seulement les précautions sont prises pour éviter la dérive du déphasage entre les deux boucles à verrouillage de phase en fonction de la dérive de la différence entre les températures des boîtiers respectifs des deux boucles à verrouillage de phase, mais aussi une détection rapide voire immédiate de cette dérive en température est alors implémentée.

Suivant des modes de réalisation préférés, l'invention comprend une ou plusieurs des caractéristiques suivantes qui peuvent être utilisées séparément ou en combinaison partielle entre elles ou en combinaison totale entre elles, avec l'un ou l'autre des objets précités de l'invention.

La zone de calibration présente une variation d'au moins 10dB de gain en puissance en sortie de la sommation cohérente des deux boucles à verrouillage de phase pour 30 degrés de déphasage entre les deux boucles à verrouillage de phase.

Ainsi, même une imprécision notable sur la mesure de puissance se traduit par une imprécision encore tout à fait acceptable pour le déphasage.

De préférence, la zone de calibration est au voisinage d'un point de fonctionnement correspondant à un gain en puissance en sortie de la sommation cohérente des deux boucles à verrouillage de phase pour un déphasage entre les deux boucles à verrouillage de phase qui correspond à un gain en puissance de -10dB. Ce point de fonctionnement correspond avantageusement au point milieu entre deux points mesurés dans la zone de calibration.

Ainsi, d'une part même une imprécision notable sur la mesure de puissance se traduit par une imprécision encore tout à fait acceptable pour le déphasage et d'autre part le niveau absolu de la puissance mesurée reste encore relativement élevé et donc relativement facile à mesurer.

De préférence, ladite zone de calibration comprend le choix de deux points présentant la même valeur de gain en puissance en sortie de la sommation cohérente des deux boucles à verrouillage de phase et étant symétriques par rapport à l'opposition de phase.

Ainsi, une moyennisation entre ces deux points va permettre d'améliorer encore la précision de la mesure.

La sommation cohérente des deux boucles à verrouillage de phase est réalisée par un combineur présentant deux voies de sortie qui sont une voie de sortie en phase et une voie de sortie en opposition de phase.

Ainsi, l'utilisation de ce combineur d'un type particulier va permettre de réaliser simultanément deux fonctions :
➢ d'une part réaliser la sommation cohérente en sortie des deux boucles à verrouillage de phase, qui sera le signal utile,
➢ et d'autre part réaliser la calibration en phase par asservissement du pilotage des deux boucles à verrouillage de phase sur une voie de sortie de ce combineur.

La calibration en phase est réalisée par une boucle de rétroaction vers les deux boucles à verrouillage de phase à partir de la voie de sortie en opposition de phase du combineur.

Ainsi, d'une part le signal de puissance variant lentement en fonction du déphasage va se retrouver sur la voie en phase et constituer un signal utile stable, tandis que d'autre part le signal de puissance variant rapidement en fonction du déphasage va se retrouver sur la voie en opposition de phase et constituer un signal de calibration sensible et donc précis.

De préférence, la calibration en phase est réalisée par une boucle de rétroaction vers les deux boucles à verrouillage de phase en pilotant, pour chaque boucle à verrouillage de phase, à la fois sa puissance et sa phase.

Ainsi, la calibration sera plus précise et plus simple à réaliser, donc globalement doublement plus efficace.

De préférence, ladite boucle de rétroaction comprend un détecteur logarithmique pour déterminer le gain en puissance en sortie de la sommation cohérente des deux boucles à verrouillage de phase en fonction du déphasage entre les deux boucles à verrouillage de phase.

Ainsi, l'extraction du déphasage à partir de la mesure de la puissance sera rendue plus directe et plus facile, la puissance en sortie de sommation cohérente des deux boucles à verrouillage de phase étant fonction du déphasage entre les deux boucles à verrouillage de phase.

Le premier seuil prédéterminé de déphasage correspond à un niveau de puissance en sortie de la sommation cohérente des deux boucles à verrouillage de phase correspondant à un déphasage compris entre 30 et 50 degrés, valant avantageusement environ 40 degrés entre les deux boucles à verrouillage de phase, le deuxième seuil prédéterminé de déphasage correspond à un niveau de puissance en sortie de la sommation cohérente des deux boucles à verrouillage de phase correspondant à un déphasage compris entre 60 et 90 degrés, valant avantageusement environ 75 degrés entre les deux boucles à verrouillage de phase.

Le premier seuil prédéterminé de déphasage correspond à un gain signal utile sur bruit blanc, au niveau de la puissance en sortie de la sommation cohérente des deux boucles à verrouillage de phase, compris entre 2 et 3 dB, valant avantageusement environ 2.5dB, le deuxième seuil prédéterminé de déphasage correspond à un niveau de puissance en sortie de la sommation cohérente des deux boucles à verrouillage de phase compris entre 0 et 2dB, valant avantageusement environ 1dB.

Ainsi, la recalibration intervient pour conserver 2.5dB du gain cible de 3dB d'amélioration du rapport signal utile sur bruit, tandis qu'en dessous de 1dB d'amélioration du rapport signal utile sur bruit, la présence de la deuxième boucle à verrouillage de phase devient pratiquement inutile et ne se justifie plus.

De préférence, le procédé de calibration en phase selon l'une quelconque des revendications précédentes est relancé d'une part à chaque démarrage du fonctionnement dudit circuit électronique et d'autre part à chaque changement de fréquence dudit circuit électronique.

Ainsi, le procédé de calibration est relancé dès lors que ledit circuit électronique subit une opération qui entraîne l'interruption de son onde porteuse, car l'interruption de cette onde porteuse entraîne une perte complète de la relation de phase entre les deux boucles à verrouillage de phase.

Un premier signal d'alarme est transmis lorsque la différence en température entre les deux capteurs dépasse un premier seuil prédéterminé de température correspondant au premier seuil prédéterminé de déphasage, et/ou un deuxième signal d'alarme est transmis lorsque la différence en température entre les deux capteurs dépasse un deuxième seuil prédéterminé de température correspondant au deuxième seuil prédéterminé de déphasage.

Ainsi, la recalibration intervient pour conserver 2.5dB du gain cible de 3dB d'amélioration du rapport signal utile sur bruit, tandis qu'en dessous de 1dB d'amélioration du rapport signal utile sur bruit, la présence de la deuxième boucle à verrouillage de phase devient pratiquement inutile et ne se justifie plus.

De préférence, le premier seuil prédéterminé de température reste inférieure à 5°C.

Ainsi, la valeur assez basse de ce premier seuil prédéterminé de température garantit de conserver la dérive du déphasage au cours du temps en fonction de la dérive de la différence de températures respectivement entre les boîtiers des deux boucles à verrouillage de phase, dans des limites raisonnables.

D'autres caractéristiques et avantages de l'invention apparaîtront à la lecture de la description qui suit d'un mode de réalisation préféré de l'invention, donnée à titre d'exemple et en référence aux dessins annexés.

### BREVE DESCRIPTION DES DESSINS

**[****Fig. 1****]** La figure 1 représente schématiquement un exemple de circuit électronique réalisant la sommation cohérente de deux boucles à verrouillage de phase selon l'art antérieur.
**[****Fig. 2****]** La figure 2 représente schématiquement un exemple de circuit électronique réalisant la sommation cohérente de deux boucles à verrouillage de phase selon un mode de réalisation de l'invention.
**[****Fig. 3****]** La figure 3 représente schématiquement un exemple de courbe de gain de puissance en sortie de sommation cohérente de deux boucles à verrouillage de phase en fonction du déphasage entre les deux boucles à verrouillage de phase, selon un mode de réalisation de l'invention.

### DESCRIPTION DETAILLEE DE L'INVENTION

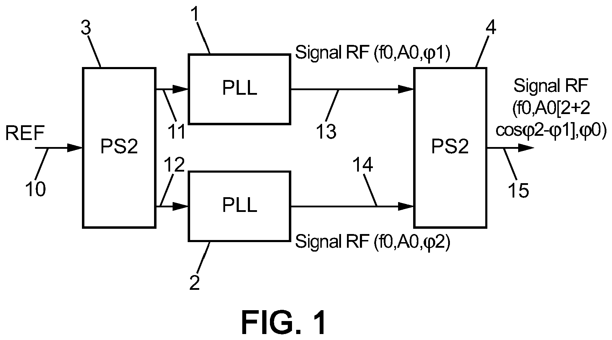

La figure 1 représente schématiquement un exemple de circuit électronique réalisant la sommation cohérente de deux boucles à verrouillage de phase selon l'art antérieur.

A partir d'une fréquence de référence 10, un diviseur 3 alimente respectivement les entrées 11 et 12 de deux boucles à verrouillage de phase 1 et 2. Un combineur 4 somme les sorties 13 et 14 respectives de ces deux boucles à verrouillage de phase 1 et 2. En sortie 15 du combineur 4, se trouve le signal utile dont l'amplitude dépend du déphasage entre les deux boucles à verrouillage de phase 1 et 2.

Sur la sortie 13 de la boucle à verrouillage de phase 1, se trouve un signal de fréquence f0, d'amplitude A0, de phase φ1. Sur la sortie 14 de la boucle à verrouillage de phase 2, se trouve un signal de fréquence f0, d'amplitude A0, de phase φ2. Sur la sortie 15 du combineur 4, se trouve un signal de fréquence f0, d'amplitude A0 (2+2cos (φ2-φ1), de phase φ0.

Le gain de la sommation est défini par 10log (2+2 cosϕ), ϕ étant le déphasage entre les boucles à verrouillage de phase 1 et 2. L'objectif va être de chercher à maintenir un gain de 5,5dB (soit 2,5dB de mieux que le bruit de phase), c'est-à-dire à garantir une variation de la phase de +/-40°. La difficulté provient du fait que les caractéristiques des boucles à verrouillage de phase 1 et 2 vont varier dans le temps et en température, et il ne sera alors plus possible de garantir la cohérence de phase entre leurs signaux de sortie. Ceci est d'autant plus vrai que la fréquence f0 de sortie des boucles à verrouillage de phase 1 et 2 est élevée.

Les boucles à verrouillage de phase 1 et 2 utilisent des composants électroniques de type PLL LMX2595 travaillant à une fréquence de 10GHz, la variation indiquée par le constructeur étant de 2,5ps/°C. A 10GHz, la période du signal radiofréquence (RF) est de 100ps, et un déphasage de 40° impliquerait de pouvoir maintenir un décalage inférieur à 11ps dans le temps de vie du composant électronique et pouvoir garantir une différence de température de 4,4°C entre les boucles à verrouillage de phase 1 et 2.

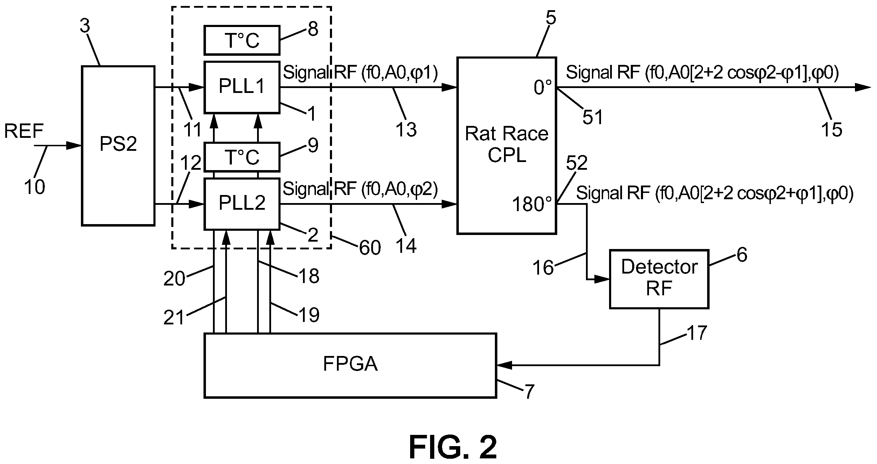

La figure 2 représente schématiquement un exemple de circuit électronique réalisant la sommation cohérente de deux boucles à verrouillage de phase selon un mode de réalisation de l'invention. Il s'agit de mettre en œuvre un mécanisme de calibration du déphasage entre les boucles à verrouillage de phase 1 et 2 qui soit transparent pour l'utilisateur du circuit électronique de sommation cohérente des boucles à verrouillage de phase 1 et 2.

A partir d'une fréquence de référence 10, par exemple comprise entre 10MHz et 100MHz, un diviseur 3 alimente respectivement les entrées 11 et 12 de deux boucles à verrouillage de phase 1 et 2. Un combineur 5, par exemple un coupleur de type « rat race », présentant deux voies de sorties, une voie 51 de sortie en phase et une voie 52 de sortie en opposition de phase, somme les sorties 13 et 14 respectives de ces deux boucles à verrouillage de phase 1 et 2, pour envoyer sur sa voie 51 de sortie en phase le signal utile 15 dont l'amplitude dépend du déphasage entre les deux boucles à verrouillage de phase 1 et 2, et pour envoyer sur sa voie 52 de sortie en opposition de phase le signal de calibration 16 dont l'amplitude dépend également du déphasage entre les deux boucles à verrouillage de phase 1 et 2.

Sur la sortie 13 de la boucle à verrouillage de phase 1, se trouve un signal de fréquence f0, d'amplitude A0, de phase φ1. Sur la sortie 14 de la boucle à verrouillage de phase 2, se trouve un signal de fréquence f0, d'amplitude A0, de phase φ2. Sur la voie 51 de sortie en phase, se trouve le signal utile de sortie 15 du combineur 5, qui est un signal de fréquence f0, d'amplitude A0 (2+2cos (φ2-φ1), de phase φ0. Sur la voie 52 de sortie en opposition de phase, se trouve le signal de calibration de sortie 16 du combineur 5, qui est un signal de fréquence f0, d'amplitude A0 (2+2cos (φ2+φ1), de phase φ0+180°. La fréquence f0 peut être comprise par exemple entre 1GHz et 10GHz, voir aller au-delà de 10GHz.

Une boucle de rétroaction part de la sortie 16 du combineur 5 pour alimenter l'entrée d'un détecteur 6 de puissance logarithme, dont la sortie 17 alimente à son tour l'entrée d'un composant électronique 7 de pilotage. Ce composant électronique 7 de pilotage pilote par sa sortie 18 la boucle à verrouillage de phase 1 en puissance. Ce composant électronique 7 de pilotage pilote par sa sortie 19 la boucle à verrouillage de phase 2 en puissance. Ce composant électronique 7 de pilotage pilote par sa sortie 20 la boucle à verrouillage de phase 1 en phase. Ce composant électronique 7 de pilotage pilote par sa sortie 21 la boucle à verrouillage de phase 2 en phase. Les sorties 19 et 21 peuvent être confondues et correspondre avantageusement alors à un bus de données qui vient adresser des fonctions différentes à l'intérieur des boucles à verrouillage de phase.

La boucle à verrouillage de phase 1 et la boucle à verrouillage de phase 2 sont disposées l'une à côté de l'autre, et sont avantageusement localisées dans la même alvéole de blindage 60. Sur la boucle à verrouillage de phase 1 est fixé un capteur de température 8. Le capteur de température 8 est avantageusement fixé sur la carte mère (PCB) en vis-à-vis de la semelle du boîtier de la boucle à verrouillage de phase 1. Sur la boucle à verrouillage de phase 2 est fixé un capteur de température 9. Le capteur de température 9 est avantageusement fixé sur la carte mère (PCB) en vis-à-vis de la semelle du boîtier de la boucle à verrouillage de phase 2.

Comme l'amplitude en sortie de combineur 5 varie en fonction du déphasage entre les boucles à verrouillage de phase 1 et 2, il est donc possible de déterminer ce déphasage en mesurant l'amplitude en sortie du combineur 5. Ce type de détection présente toutefois un inconvénient qui est une sensibilité importante par rapport à la variation de puissance des signaux laquelle sensibilité peut fausser la mesure. Le procédé de calibration en phase intègre donc une mesure de puissance pour chacune des deux boucles à verrouillage de phase 1 et 2.

La puissance est plus déterminée ou indirectement mesurée que directement mesurée, car c'est le détecteur logarithmique mesure une puissance et le gain est une différence de puissance. Ainsi, le gain est ensuite déduit à partir de la mesure de puissance initiale pour une seule boucle à verrouillage de phase.

La calibration de phase est réalisée sur la voie 52 de sortie en opposition de phase du combineur 5. Lorsque l'opposition de phase est obtenue sur la voie 52 de sortie en opposition de phase (180°), le signal utile 15 sera alors en phase sur la voie 51 de sortie en phase. La voie 52 de sortie en opposition de phase (180°) est utilisée plutôt que la voie 51 de sortie en phase, car la variation logarithmique est beaucoup plus rapide lorsque le signal est quasiment nul, ce qui correspond à la zone de calibration 34 sur la figure 3 ci-dessous, rendant alors la calibration plus précise et le risque d'indécision par rapport à un décalage des amplitudes nettement plus faible.

La figure 3 représente schématiquement un exemple de courbe de gain de puissance en sortie de sommation cohérente de deux boucles à verrouillage de phase en fonction du déphasage entre les deux boucles à verrouillage de phase, selon un mode de réalisation de l'invention. La courbe de gain ne prend pas en compte les pertes du combineur.

Pour la courbe 30, l'axe des ordonnées représente la valeur du gain de puissance en sortie de sommation cohérente de deux boucles à verrouillage de phase, exprimée en dB, tandis que l'axe des abscisses représente la valeur du déphasage entre les deux boucles à verrouillage de phase, exprimée en degrés.

La courbe 40 représente une valeur constante et prise comme référence à la valeur zéro, de la puissance en sortie d'une unique boucle à verrouillage de phase.

La courbe 30 est périodique, elle se présente sous la forme d'une sorte de parabole inversée. Cette courbe 30 présente trois zones :
➢ une zone 31, plutôt horizontale, correspondant au somment de la parabole inversée, dans laquelle le gain en puissance en sortie de sommation cohérente de deux boucles à verrouillage de phase varie lentement en fonction du déphasage entre les deux boucles à verrouillage de phase,
> une zone 32, plutôt inclinée, correspondant à la jonction entre d'une part le somment de la parabole inversée et d'autre part les branches de la parabole inversée, dans laquelle le gain en puissance en sortie de sommation cohérente de deux boucles à verrouillage de phase varie de manière intermédiaire en fonction du déphasage entre les deux boucles à verrouillage de phase,
➢ une zone 33, plutôt verticale, correspondant aux branches de la parabole inversée, dans laquelle le gain en puissance en sortie de sommation cohérente de deux boucles à verrouillage de phase varie rapidement en fonction du déphasage entre les deux boucles à verrouillage de phase.

La zone de calibration 34 est choisie correspondante à la zone 33 plutôt verticale de variation rapide de la puissance en fonction du déphasage, c'est-à-dire au niveau des branches de la parabole inversée formée par la courbe 30. Deux points de gain à -10dB, P1 et P2, sont choisis. Le milieu du segment [P1 P2] est le point P0. Le segment [P1 P2] s'étend sur environ 30 degrés de déphasage.

Le procédé de calibration en phase va être réalisé à chaque démarrage et à chaque changement de fréquence, car l'un comme l'autre nécessitent une interruption de l'onde porteuse du signal utile. L'algorithme correspondant à ce procédé de calibration va être implémenté dans le composant 17 de pilotage des deux boucles à verrouillage de phase, ce composant 17 pouvant être un composant électronique de type FPGA.

Le procédé de calibration en phase se déroule successivement de la façon suivante :
➢ dans une première étape, la boucle à verrouillage de phase 1 est seule allumée, la puissance de cette boucle à verrouillage de phase 1 est réglée pour obtenir une amplitude A0 en sortie 13,
➢ dans une deuxième étape, la boucle à verrouillage de phase 2 est seule allumée, la puissance de cette boucle à verrouillage de phase 2 est réglée pour obtenir une amplitude A0 en sortie 14,
➢ dans une troisième étape, les deux boucles à verrouillage de phase 1 et 2 sont allumées ensemble, les puissances de ces deux boucles à verrouillage de phase 1 et 2 sont respectivement réglées pour obtenir l'amplitude A0 en sorties 13 et 14, ou bien une valeur proche de cette amplitude A0,
➢ dans une quatrième étape, par pas de 20°, on vient trouver le point le plus proche du gain à -10dB sur la courbe,
➢ dans une cinquième étape, par pas de 2°, on trouve le point P1 le plus proche du gain à -10dB sur la courbe 30,
> dans une sixième étape, pour trouver le point P2, par pas de 2°, on se déplace dans le sens d'une diminution du gain jusqu'à obtenir le point P2 le plus proche d'un gain de -10dB,
> dans une septième étape, pour garantir un signal utile 15 en phase, on se place alors au point P0 = (P1 + P2) /2,
> dans une huitième étape, on définit alors la limite de calibration cohérente en se plaçant à (P1 + P2) /2 + 40°, ce qui correspond à un gain sur le bruit de phase valant environ 2,5dB, et la valeur de puissance Pseuil_coherente obtenue est sauvegardée,
> dans une neuvième étape, on définit alors la limite de calibration nominale en se plaçant à (P1 + P2) /2 + 75°, et la valeur de puissance Pseuil_nominal obtenue, correspondant à un gain sur bruit de phase valant environ 1dB, est sauvegardée.

Ensuite, le procédé de fonctionnement du circuit électronique réalisant la sommation cohérente des deux boucles à verrouillage de phase 1 et 2, se déroule successivement de la façon suivante :
> lorsque le niveau sur le détecteur de la voie 52 de sortie en opposition de phase dépasse la valeur Pseuil_nominal, on coupe la deuxième boucle à verrouillage de phase 2, les performances avec le circuit électronique réalisant la sommation cohérente des deux boucles à verrouillage de phase 1 et 2 seraient plus dégradées qu'avec une seule boucle à verrouillage de phase 1,
> lorsque le niveau sur le détecteur de la voie 52 en opposition de phase dépasse la valeur Pseuil_cohérent, on coupe la deuxième boucle à verrouillage de phase 2, puis le procédé de calibration en phase est relancé. Connaissant la température de chacune des deux boucles à verrouillage de phase 1 et 2, il devient alors possible de déterminer laquelle des deux boucles à verrouillage de phase 1 et 2 est en avance de phase sur l'autre, ce qui permet ensuite de recaler de + ou -40° la phase de la deuxième boucle à verrouillage de phase 2 à son démarrage.

Si on dépasse une certaine différence en température entre les deux boucles à verrouillage de phase 1 et 2, les deux boucles à verrouillage de phase 1 et 2 vont être recalibrées en phase par l'intermédiaire du procédé de calibration en phase proposé par l'invention. Cette différence en température va dépendre des composants particuliers formant respectivement les deux boucles à verrouillage de phase 1 et 2, ainsi que de leur fréquence f0 de fonctionnement.

Lors de l'implémentation de ce circuit électronique réalisant la sommation cohérente des deux boucles à verrouillage de phase 1 et 2, ces deux boucles à verrouillage de phase 1 et 2 vont être localisées l'une à côté de l'autre, chacune respectivement avec un capteur de température 8 ou 9 sur la carte mère électronique tout contre la semelle du boîtier de chacune de ces deux boucles à verrouillage de phase 1 et 2 lesquelles sont également avantageusement montées dans la même alvéole de blindage 60.

En option supplémentaire, si l'environnement climatique de l'ensemble du circuit électronique réalisant la sommation cohérente des deux boucles à verrouillage de phase 1 et 2 présente des variations lentes de température, il sera alors possible d'étendre la plage de température en calibrant le déphasage à -40° si on sait qu'à chaque démarrage, on a un cycle de calibration de +40° à faire, de manière à ainsi pouvoir doubler la plage de température.

La portée de la présente invention est définie par les revendications.

## Revendications

1. Procédé de calibration en phase d'un circuit électronique réalisant la sommation cohérente (4) de deux boucles à verrouillage de phase (1, 2), effectuant la calibration en phase des deux boucles à verrouillage de phase dans une zone de calibration (34) qui présente, en une voie de sortie en opposition de phase d'un combineur compris dans le circuit électronique et réalisant la sommation
cohérente des deux boucles à verrouillage de phase (1, 2), une variation d'au moins 10dB de gain en puissance pour 30 degrés de déphasage entre les deux boucles à verrouillage de phase (1, 2),
le combineur (4) présentant deux voies de sortie (51, 52) qui sont une voie de sortie en phase (51) et ladite voie de sortie en opposition de phase (52),
dans lequel la calibration en phase est réalisée par une boucle de rétroaction (6, 7) vers les deux boucles à verrouillage de phase (1, 2) à partir de la voie de sortie en opposition de phase (52) du combineur (4).

2. Procédé de calibration en phase selon la revendication 1, **caractérisé en ce que** la zone de calibration (34) est au voisinage d'un point de fonctionnement correspondant à un gain en puissance en sortie de la sommation cohérente des deux boucles à verrouillage de phase (1, 2) pour un déphasage entre les deux boucles à verrouillage de phase (1, 2) qui correspond à un gain en puissance de -10dB.

3. Procédé de calibration en phase selon l'une quelconque des revendications précédentes, **caractérisé en ce que** la courbe (30), du gain en puissance en fonction du déphasage entre les deux boucles à verrouillage de phase (1, 2) en sortie de la sommation cohérente des deux boucles à verrouillage de phase (1, 2), présente une forme de parabole inversée, et **en ce que** la zone de calibration (34) est choisie au niveau d'une branche ou des branches (33) de cette parabole inversée, mais ni au niveau du dôme (31) de cette parabole inversée ni au niveau de la zone intermédiaire (32) entre ce dôme (31) et ces branches (33).

4. Procédé de calibration en phase selon l'une quelconque des revendications précédentes, **caractérisé en ce que** ladite zone de calibration (34) comprend le choix de deux points (P1, P2) présentant la même valeur de gain en puissance en sortie de la sommation cohérente des deux boucles à verrouillage de phase (1, 2) et étant symétriques par rapport à l'opposition de phase.

5. Procédé de calibration en phase selon l'une quelconque des revendications précédentes, **caractérisé en ce que** la calibration en phase est réalisée par la boucle de rétroaction (6, 7) vers les deux boucles à verrouillage de phase (1, 2) en pilotant, pour chaque boucle à verrouillage de phase (1, 2), à la fois sa puissance et sa phase.

6. Procédé de calibration en phase selon l'une quelconque des revendications précédentes, **caractérisé en ce que** ladite boucle de rétroaction (6, 7) comprend un détecteur logarithmique (6) pour déterminer le gain en puissance en sortie de la sommation cohérente des deux boucles à verrouillage de phase (1, 2) en fonction du déphasage entre les deux boucles à verrouillage de phase (1, 2).

7. Procédé de fonctionnement dudit circuit électronique, **caractérisé en ce que**, lors du fonctionnement dudit circuit électronique, au-delà d'un premier seuil prédéterminé de déphasage mesuré entre les deux boucles à verrouillage de phase (1, 2), le procédé de calibration en phase selon l'une quelconque des revendications précédentes est relancé au cours du fonctionnement dudit circuit électronique, au-delà d'un deuxième seuil prédéterminé de déphasage, la deuxième boucle à verrouillage de phase (2) est coupée, le deuxième seuil prédéterminé de déphasage étant strictement supérieur au premier seuil prédéterminé de déphasage,
**en ce que** le premier seuil prédéterminé de déphasage correspond à un niveau de puissance en sortie de la sommation cohérente des deux boucles à verrouillage de phase (1, 2) correspondant à un déphasage compris entre 30 et 50 degrés, valant avantageusement environ 40 degrés entre les deux boucles à verrouillage de phase (1, 2), et **en ce que** le deuxième seuil prédéterminé de déphasage correspond à un niveau de puissance en sortie de la sommation cohérente des deux boucles à verrouillage de phase (1, 2) correspondant à un déphasage compris entre 60 et 90 degrés, valant avantageusement environ 75 degrés entre les deux boucles à verrouillage de phase (1, 2),
et/ou **en ce que** le premier seuil prédéterminé de déphasage correspond à un gain signal utile sur bruit blanc, au niveau de la puissance en sortie de la sommation cohérente des deux boucles à verrouillage de phase (1, 2), compris entre 2 et 3 dB, valant avantageusement environ 2.5dB, et **en ce que** le deuxième seuil prédéterminé de déphasage correspond à un niveau de puissance en sortie de la sommation cohérente des deux boucles à verrouillage de phase (1, 2) compris entre 0 et 2dB, valant avantageusement environ 1dB.

8. Procédé de fonctionnement dudit circuit électronique selon la revendication 7, **caractérisé en ce que** le procédé de calibration en phase selon l'une quelconque des revendications précédentes est relancé d'une part à chaque démarrage du fonctionnement dudit circuit électronique et d'autre part à chaque changement de fréquence dudit circuit électronique.

9. Circuit électronique réalisant la sommation cohérente de deux boucles à verrouillage de phase, comprenant, la succession d'un générateur de fréquence de référence (10), d'un diviseur (3), de deux boucles à verrouillage de phase (1, 2) disposées en parallèle l'une de l'autre, d'un combineur (4) réalisant la sommation cohérente des deux boucles à verrouillage de phase (1, 2), une boucle de rétroaction (6, 7) vers les deux boucles à verrouillage de phase (1, 2) à partir de la voie de sortie du combineur (4) en opposition de phase (52) lorsque ce combineur (4) présente deux voies de sortie qui sont une voie de sortie en phase (51) et une voie de sortie en opposition de phase (52), deux capteurs de température (8, 9), respectivement fixés sur les deux boîtiers des deux boucles à verrouillage de phase (1, 2), avantageusement respectivement contre les semelles de ces boîtiers, ces deux capteurs (8, 9) et leurs deux boucles à verrouillage de phase (1, 2) associées étant avantageusement montés à l'intérieur d'un même boîtier de blindage (60),
et en ce qu'un premier signal d'alarme est transmis lorsque la différence en température entre les deux capteurs (8, 9) dépasse un premier seuil prédéterminé de température correspondant au premier seuil prédéterminé de déphasage, et/ou un deuxième signal d'alarme est transmis lorsque la différence en température entre les deux capteurs (8, 9) dépasse un deuxième seuil prédéterminé de température correspondant au deuxième seuil prédéterminé de déphasage, les premier et deuxième seuils prédéterminés de déphasage étant déterminés selon le procédé de la revendication 7.

10. Circuit électronique selon la revendication 9, **caractérisé en ce que** le premier seuil prédéterminé de température reste inférieure à 5°C.

## Patentansprüche

1. Verfahren zur Phasenkalibrierung einer elektronischen Schaltung, welche die kohärente Summation (4) zweier Phasenregelkreise (1, 2) durchführt, wobei die Phasenkalibrierung der beiden Phasenregelkreise in einer Kalibrierungszone (34) durchgeführt wird, welche an einem gegenphasigen Ausgangskanal eines in der elektronischen Schaltung enthalten Kombinierers, welcher die kohärente Summation der beiden Phasenregelkreise (1, 2) durchführt, aufweist,
wobei der Kombinierer (4) zwei Ausgangskanäle (51, 52) aufweist, welche ein gleichphasiger Ausgangskanal (51) und ein gegenphasiger Ausgangskanal (52) sind,
wobei die Phasenkalibrierung durch eine Rückkopplungsschleife (6, 7) zu den beiden Phasenregelkreisen (1, 2) ausgehend von dem gegenphasigen Ausgangskanal (52) des Kombinierers (4) ausgeführt ist.

2. Phasenkalibrierungsverfahren nach Anspruch 1, **dadurch gekennzeichnet, dass** die Kalibrierungszone (34) in der Nähe eines Arbeitspunkts liegt, welcher einer Leistungsverstärkung am Ausgang der kohärenten Summation der beiden Phasenregelkreise (1, 2) bei einer Phasenverschiebung zwischen den beiden Phasenregelkreisen (1, 2) entspricht, welche einer Leistungsverstärkung von -10 dB entspricht.

3. Phasenkalibrierungsverfahren nach einem der vorhergehenden Ansprüche, **dadurch gekennzeichnet, dass** die Kurve (30) der Leistungsverstärkung als Funktion der Phasenverschiebung zwischen den beiden Phasenregelkreisen (1, 2) am Ausgang der kohärenten Summation der beiden Phasenregelkreise (1, 2) eine Form einer umgekehrten Parabel aufweist und dass die Kalibrierungszone (34) auf dem Niveau eines oder mehrerer Zweige (33) dieser umgekehrten Parabel gewählt wird, jedoch weder auf der Höhe des Scheitels (31) dieser umgekehrten Parabel noch auf der Höhe der Zwischenzone (32) zwischen diesem Scheitel (31) und diesen Zweigen (33).

4. Phasenkalibrierungsverfahren nach einem der vorhergehenden Ansprüche, **dadurch gekennzeichnet, dass** die Kalibrierungszone (34) die Auswahl zweier Punkte (P1, P2) umfasst, welche den gleichen Leistungsverstärkungswert am Ausgang der kohärenten Summation der beiden Phasenregelkreise (1, 2) aufweisen und bezüglich der Phasenopposition symmetrisch sind.

5. Phasenkalibrierungsverfahren nach einem der vorhergehenden Ansprüche, **dadurch gekennzeichnet, dass** die Phasenkalibrierung durch die Rückkopplungsschleife (6, 7) zu den beiden Phasenregelkreisen (1, 2) erfolgt, indem für jeden Phasenregelkreis (1, 2) sowohl seine Leistung als auch seine Phase geführt werden.

6. Phasenkalibrierungsverfahren nach einem der vorhergehenden Ansprüche, **dadurch gekennzeichnet, dass** die Rückkopplungsschleife (6, 7) einen logarithmischen Detektor (6) zur Bestimmung der Leistungsverstärkung am Ausgang der kohärenten Summation der beiden Phasenregelschleifen (1, 2) als Funktion der Phasenverschiebung zwischen den beiden Phasenregelschleifen (1, 2) umfasst.

7. Verfahren zum Betrieb der elektronischen Schaltung, **dadurch gekennzeichnet, dass** während des Betriebs der elektronischen Schaltung jenseits eines ersten vorbestimmten Phasenverschiebung-Schwellenwerts, welcher zwischen den beiden Phasenregelkreisen (1, 2) gemessen wird, das Phasenkalibrierungsverfahren nach einem der vorhergehenden Ansprüche während des Betriebs der elektronischen Schaltung neu gestartet wird, wobei jenseits eines zweiten vorbestimmten Phasenverschiebung-Schwellenwerts der zweite Phasenregelkreis (2) abgeschaltet wird, wobei der zweite vorbestimmte Phasenverschiebung-Schwellenwert strikt größer ist als der erste vorbestimmte Phasenverschiebung-Schwellenwert,
dass der erste vorbestimmte Phasenverschiebung-Schwellenwert einem Ausgangsleistungspegel der kohärenten Summation der beiden Phasenregelkreise (1, 2) entspricht, entsprechend einer Phasenverschiebung zwischen 30 und 50 Grad, vorzugsweise etwa 40 Grad, zwischen den beiden Phasenregelkreisen (1, 2), und dass der zweite vorbestimmte Phasenverschiebung-Schwellenwert einem Ausgangsleistungsniveau der kohärenten Summation der beiden Phasenregelkreise (1, 2) entspricht, entsprechend einer Phasenverschiebung zwischen 60 und 90 Grad, vorzugsweise etwa 75 Grad, zwischen den beiden Phasenregelkreisen (1, 2),
und/oder dass der erste vorbestimmte Phasenverschiebung-Schwellenwert einer Nutzsignalverstärkung auf weißes Rauschen auf dem Niveau der Ausgangsleistung der kohärenten Summation der beiden Phasenregelkreise (1, 2) zwischen 2 und 3 dB, vorzugsweise etwa 2,5 dB, entspricht, und dass der zweite vorbestimmte Phasenverschiebung-Schwellenwert einer Ausgangsleistung der kohärenten Summation der beiden Phasenregelkreise (1, 2) zwischen 0 und 2 dB, vorzugsweise etwa 1 dB, entspricht.

8. Verfahren zum Betrieb der elektronischen Schaltung nach Anspruch 7, **dadurch gekennzeichnet, dass** das Phasenkalibrierungsverfahren nach einem der vorhergehenden Ansprüche einerseits bei jedem Betriebsstart der elektronischen Schaltung und andererseits bei jeder Frequenzänderung der elektronischen Schaltung neu gestartet wird.

9. Elektronische Schaltung, welche die kohärente Summation zweier Phasenregelkreise ausführt, umfassend die Abfolge eines Referenzfrequenzgenerators (10), eines Teilers (3), zweier parallel zueinander angeordneter Phasenregelkreise (1, 2), eines Kombinierers (4), welcher die kohärente Summation der beiden Phasenregelkreise (1, 2) ausführt, einer Rückkopplungsschleife (6, 7) zu den beiden Phasenregelkreisen (1, 2) von dem Ausgangskanal des Kombinierers (4) in Gegenphase (52), wenn dieser Kombinierer (4) zwei Ausgangskanäle aufweist, welche ein phasengleicher Ausgangskanal (51) und ein gegenphasiger Ausgangskanal (52) sind, zweier Temperatursensoren (8, 9), welche jeweils an den beiden Gehäusen der beiden Phasenregelkreise (1, 2) befestigt sind, vorzugsweise jeweils gegen die Grundplatten dieser Gehäuse, wobei diese beiden Sensoren (8, 9) und ihre beiden zugeordneten Phasenregelkreise (1, 2) vorzugsweise im Inneren eines gleichen Abschirmgehäuses (60) montiert sind,
und dass ein erstes Alarmsignal gesendet wird, wenn die Temperaturdifferenz zwischen den beiden Sensoren (8, 9) einen ersten vorbestimmten Temperaturschwellenwert überschreitet, welcher dem ersten vorbestimmten Phasenverschiebung-Schwellenwert entspricht, und/oder dass ein zweites Alarmsignal gesendet wird, wenn die Temperaturdifferenz zwischen den beiden Sensoren (8, 9) einen zweiten vorbestimmten Temperaturschwellenwert überschreitet, welcher dem zweiten vorbestimmten Phasenverschiebung-Schwellenwert entspricht, wobei der erste und der zweite vorbestimmte Phasenverschiebung-Schwellenwert gemäß dem Verfahren nach Anspruch 7 bestimmt werden.

10. Elektronische Schaltung nach Anspruch 9, **dadurch gekennzeichnet, dass** der erste vorbestimmte Temperaturschwellenwert unter 5 °C verbleibt.

## Claims

1. A method of phase-calibration of an electronic circuit performing coherent summation (4) of two phase-locked loops (1, 2), carrying out the phase-calibration of both phase-locked loops in a calibration zone (34) which has, in a phase inversion output channel of a combiner comprised in the electronic circuit and performing the coherent summation of both phase-locked loops (1, 2), a variation of at least 10 dB in power gain for 30 degrees in phase difference between both phase-locked loops (1, 2),
the combiner (4) having two output channels (51, 52) that are an in-phase output channel (51) and said phase inversion output channel (52),
wherein the phase-calibration is performed by a feedback loop (6, 7) to both phase-locked loops (1, 2) from the phase inversion output channel (52) of the combiner (4).

2. The method of phase-calibration according to claim 1, **characterised in that** the calibration zone (34) is in the vicinity of an operating point corresponding to a power gain at the output of the coherent summation of both phase-locked loops (1, 2) for a phase difference between both phase-locked loops (1, 2) which corresponds to a power gain of -10dB.

3. The method of phase-calibration according to any one of the preceding claims, **characterised in that** the curve (30) of the power gain as a function of the phase difference between both phase-locked loops (1, 2) at the output of the coherent summation of both phase-locked loops (1, 2), has an inverted parabola shape, and **in that** the calibration zone (34) is chosen at a branch or branches (33) of this inverted parabola, but not at the dome (31) of this inverted parabola and not at the intermediate zone (32) between this dome (31) and these branches (33).

4. The method of phase-calibration according to any one of the preceding claims, **characterised in that** said calibration zone (34) comprises the choice of two points (P1, P2) having the same power gain value at the output of the coherent summation of both phase-locked loops (1, 2) and being symmetrical with respect to the phase inversion.

5. The method of phase-calibration according to any one of the preceding claims, **characterised in that** the phase calibration is performed by the feedback loop (6, 7) to both phase-locked loops (1, 2) by controlling, for each phase-locked loop (1, 2), both its power and its phase.

6. The method of phase-calibration according to any one of the preceding claims, **characterised in that** said feedback loop (6, 7) comprises a logarithmic detector (6) for determining the power gain at the output of the coherent summation of both phase-locked loops (1, 2) as a function of the phase difference between both phase-locked loops (1, 2).

7. An operation method of said electronic circuit, **characterised in that**, during operation of said electronic circuit, beyond a first predetermined phase difference threshold measured between both phase-locked loops (1, 2), the method of phase-calibration according to any one of the preceding claims is restarted during operation of said electronic circuit, beyond a second predetermined phase difference threshold, the second phase-locked loop (2) is turned off, the second predetermined phase difference threshold being strictly greater than the first predetermined phase difference threshold,
**in that** the first predetermined phase difference threshold corresponds to a power level at the output of the coherent summation of both phase-locked loops (1, 2) corresponding to a phase difference of between 30 and 50 degrees, advantageously of about 40 degrees between both phase-locked loops (1, 2), and **in that** the second predetermined phase difference threshold corresponds to an output power level of the coherent summation of both phase-locked loops (1, 2) corresponding to a phase difference of between 60 and 90 degrees, advantageously of about 75 degrees between both phase-locked loops (1, 2),
and/or **in that** the first predetermined phase difference threshold corresponds to a gain of useful signal over white noise, at the output power of the coherent summation of both phase-locked loops (1, 2), of between 2 and 3 dB, advantageously of about 2.5dB, and **in that** the second predetermined phase difference threshold corresponds to an output power level of the coherent summation of both phase-locked loops (1, 2) of between 0 and 2dB, advantageously of about 1dB.

8. The operation method of said electronic circuit according to claim 7, **characterised in that** the method of phase-calibration according to any one of the preceding claims is restarted at each start of the operation of said electronic circuit one the one hand and at each change in frequency of said electronic circuit on the other hand.

9. An electronic circuit performing coherent summation of two phase-locked loops, comprising the succession of a reference frequency generator (10), a divider (3), two phase-locked loops (1, 2) arranged in parallel to one another, a combiner (4) performing the coherent summation of both phase-locked loops (1, 2), a feedback loop (6, 7) to both phase-locked loops (1, 2) from the phase inversion output channel (52) of the combiner (4) when this combiner (4) has two output channels that are an in-phase output channel (51) and a phase inversion output channel (52), two temperature sensors (8, 9), respectively fastened on the two housings of both phase-locked loops (1, 2), advantageously respectively against the base plates of these housings, these two sensors (8, 9) and their two associated phase-locking loops (1, 2) being advantageously mounted inside a same shielding housing (60),
and in that a first alarm signal is transmitted when the temperature difference between both sensors (8, 9) exceeds a first predetermined temperature threshold corresponding to the first predetermined phase difference threshold, and/or a second alarm signal is transmitted when the temperature difference between both sensors (8, 9) exceeds a second predetermined temperature threshold corresponding to the second predetermined phase difference threshold, the first and second predetermined phase difference thresholds being determined according to the method of claim 7.

10. The electronic circuit according to claim 9, **characterised in that** the first predetermined temperature threshold remains below 5°C.
